# EUROPÄISCHE PATENTSCHRIFT

(11) **EP 0 747 772 B1**
(45) Veröffentlichungstag und Bekanntmachung des Hinweises auf die Patenterteilung: **14.04.2004**
(21) Anmeldenummer: 96106816.0
(22) Anmeldetag: 30.04.1996
(51) Int. Cl.: G03F 7/20

(54) **Beleuchtungseinrichtung für ein Projektions-Mikrolithographie-Gerät**
Illumination device for a projection microlithography tool
Dispositif d'illumination pour un appareil de microlithographie par projection

(30) Priorität: 06.06.1995 DE 19520563
(43) Veröffentlichungstag der Anmeldung: 11.12.1996
(73) Patentinhaber: Carl Zeiss SMT AG, 73447 Oberkochen (DE)
(72) Erfinder: Wangler, Johannes, 89551 Königsbronn (DE); Ittner, Gerhard, 73447 Oberkochen (DE)
(74) Vertreter: Müller-Rissmann, Werner Albrecht, Dr.

(56) Entgegenhaltungen:
- EP-A- 0 312 341
- EP-A- 0 486 316
- EP-A- 0 744 664
- EP-A- 1 202 100
- WO-A-94/11781
- DE-A- 4 124 311
- DE-U- 9 409 744
- JP-A- 6 196 389
- US-A- 4 497 015
- US-A- 4 918 583
- US-A- 4 939 630
- US-A- 5 237 367
- US-A- 5 359 388
- US-A- 5 386 266
- US-A- 5 392 094
- US-A- 5 631 721
- US-A- 5 636 003
- US-A- 5 675 401
- US-B- 6 198 793
- WANGLER J. ET AL: PROC. SPIE, 1989, USA, ISSN 0277-786X, VOL. 1138, PAGES 129 - 136

## Beschreibung

Die Erfindung betrifft eine Beleuchtungseinrichtung für ein Projektions-Mikrolithographie-Gerät mit einem Laser und einem Objektiv.

Eine solche Einrichtung ist z.B. in der nicht vorveröffentlichten Patentanmeldung DE-P 44 21 053 beschrieben.

Als Lichtquellen für die Mikrolithographie werden Laser primär deshalb verwendet, weil sie sehr schmalbandiges Licht emittieren und, im Falle von Excimer-Lasern, Licht sehr geringer Wellenlänge im tiefen UV-Bereich emittieren. Ihre zeitliche und räumliche Kohärenz, sowie der geringe Querschnitt und die geringe Divergenz des Lichtbündels sind jedoch der Situation bei Beleuchtungseinrichtungen für die Mikrolithographie nicht angepaßt.

Durch einzelne abbildende optische Elemente im Lichtbündelquerschnitt können Querschnitt und Divergenz nicht verändert werden - der Lichtleitwert kann nicht vergrößert werden (vgl. Young, M., Optics and Lasers, Berlin 1984, Seite 51, sowie Mütze, K., ABC der Optik, Hanau 1961, Seite 477f).
Eng verwandt mit der Erhaltung des Lichtleitwerts ist die Lagrange-Invariante (vgl. Young, a.a.O., Seite 50/51).

Zur Vergrößerung des Lichtleitwerts sind Streuelemente bekannt. Üblich sind dafür mattgeätzte Glas- oder Quarzglasplatten mit statistisch orientierten Mikro-Flächen, die brechend, reflektierend oder beugend wirken. Das Streuprofil solcher Streuplatten ist sehr stark mittenbetont, verteilt aber auch noch erhebliche Energie in einem Verteilungsschwanz bei großen Winkeln.

Gezielte Strahlverteilungen mit Divergenz- und Querschnittsvergrößerung sind mit Linsenrastern erzielbar, die für den UV- und DUV-Bereich erhältlich sind.

Diffraktive optische Rasterelemente in Quarz können durch Photolithographie in unterschiedlichsten Ausführungen hergestellt werden und können Rasterlinsenplatten substituieren.

Die EP 0 312 341 beschreibt eine Waferbelichtungsanlage mit Waferstepper, Projektionsobjektiv, Excimer-Laser, Strahlformungs- und Aufweitoptik und einem Beleuchtungssystem mit mehreren Linsengruppen, in dessen Eintrittspupille und einer weiteren Ebene zwei divergenzerzeugende Elemente vorgesehen sind. Im Unterschied zur vorliegenden Erfindung ist die zweite Ebene ebenfalls eine Pupillenebene und die beiden Elemente sind stochastische Streuscheiben mit streuenden Silizium-Kristalliten. Auch ist zusätzlich ein oszillierender Spiegel vorgesehen.

Das ganze dient zur Reduktion der räumlichen Kohärenz. Die Bedeutung der Anpassung der räumlichen Kohärenz durch Vergrößerung der effektiven Lichtquelle für Waferbelichtungsanlagen wird beschrieben.

Eine anamorphotische Wirkung können die beiden Streuscheiben nicht haben. Zoom, Axicon und Glasstab sind nicht beschrieben. Ein nicht gerastertes diffraktives optisches Element in Form eines geblazten Transmissionsgitters mit konzentrischen Mehrplateau-Ringen ist in der Pupille des Projektionsobjektivs zur Korrektur von Aberrationen der Wellenfront vorgesehen.

Aus der JP 6-196 389 A ist eine gattungsgemäße Beleuchtungseinrichtung bekannt.

Bei einer Beleuchtungseinrichtung für ein Projektions-Mikrolithographie-Gerät mit einem Laser und einem Objektiv ist dabei in der Objektebene und der Austrittspupille des Objektivs oder in dazu äquivalenten Ebenen je ein optisches Rasterelement mit zweidimensionaler Rasterstruktur angeordnet.

Aufgabe der Erfindung ist es, dabei das Objektiv mit guter Korrektur kostengünstig auszuführen.

Gelöst wird diese Aufgabe durch eine Beleuchtungseinrichtung mit den Merkmalen des Anspruchs 1.

Dabei wird, eine gattungsgemäße Beleuchtungseinrichtung angegeben, die mit hohem Wirkungsgrad bei mäßiger Komplexität eine Beleuchtung des Wafers mit geeigneter Form des Lichtflecks, Divergenz, Kohärenz und Homogenität ergibt, und zwar wahlweise sowohl für Wafer-Stepper als auch für Wafer-Scanner.

Mit diesen so angeordneten zwei Rasterelementen läßt sich die erforderliche Divergenzvergrößerung des Laserlichts gezielt zu einer Formung des Lichtbündels nutzen, die besten Wirkungsgrad und vereinfachte Gestaltung der weiteren optischen Baugruppen ermöglicht.

Vorteilhafte Ausführungen sind Gegenstand der Unteransprüche 2 bis 23.

Ein besonders vorteilhaftes Ausführungsbeispiel ist in der Zeichnung dargestellt und wird zur näheren Beschreibung der Erfindung benutzt.
- Figur 1: zeigt eine schematisches Übersicht über eine erfindungsgemäße Beleuchtungseinrichtung;
- Figur 2a: zeigt ein Rasterelement des ersten diffraktiven optischen Elements schematisch in Ansicht;
- Figur 2b: zeigt ein Phasenprofil des diffraktiven Rasterelements nach Figur 2a;
- Figur 3a: zeigt ein Rasterelement des zweiten diffraktiven optischen Elements schematisch in Ansicht;
- Figur 3b: zeigt ein Phasenprofil davon;
- Figur 3c: zeigt ein Phasenprofil eines alternativen binären diffraktiven optischen Elements.

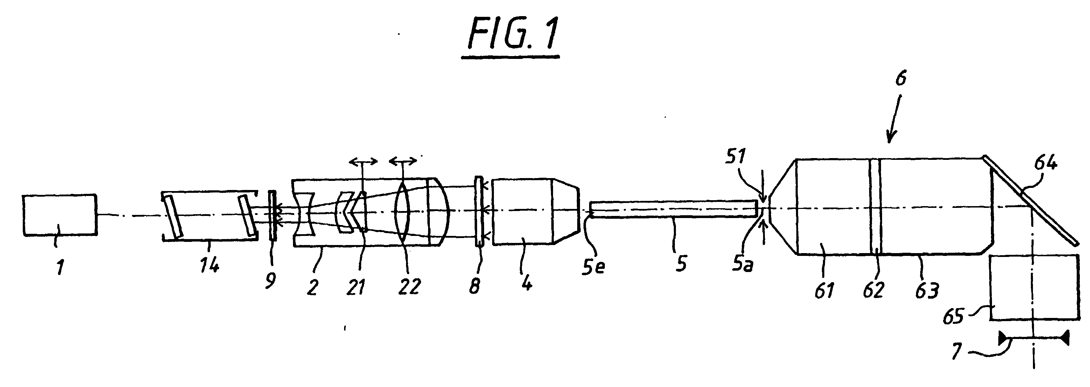

Die Figur 1 ist weitgehend als Kombination der Figuren 4d (Laser 1 bis zweites diffraktives optisches Element 8) und 4c (Rest bis Reticle 7) in der nicht vorveröffentlichten Anmeldung DE-P 44 21 053 des gleichen Anmelders beschrieben. Neu ist das erste diffraktive optische Element 9 und das Zusammenwirken mit dem zweiten diffraktiven optischen Element 8.

Der Laser 1 ist ein in der Mikrolithographie im tiefen Ultraviolett (DUV) gebräuchlicher KrF-Excimer-Laser mit 248 nm Wellenlänge, wie z.B. in EP 0 312 341 angegeben.

Ein Strahlaufweiter 14, z.B. eine Spiegelanordnung nach DE-A 41 24 311 dient zur Kohärenzreduktion und Vergrößerung des Strahlquerschnitts auf z.B. y = 35 ± 10 mm, x = 10 ± 5 mm.

Der Verschluß 13 kann auch durch eine entsprechende Pulssteuerung des Lasers 1 ersetzt sein.

Ein erstes diffraktives optisches Rasterelement 9 ist erfindungsgemäß vorgesehen und bildet die Objektebene eines Objektivs 2, in dessen Austrittspupille das zweite diffraktive optische Rasterelement 8 vorgesehen ist.

Eine Einkoppeloptik 4 überträgt das Licht auf die Eintrittsfläche 5e eines Glasstabs 5, der durch mehrfache innere Reflexion das Licht mischt und homogenisiert. Unmittelbar an der Austrittsfläche 5a ist eine Zwischenfeldebene, in der ein Reticle-Masking-System (REMA) 51, eine verstellbare Feldblende, angeordnet ist. Das nachfolgende Objektiv 6, mit Linsengruppen 61, 63, 65, Umlenkspiegel 64 und Pupillenebene 62 bildet die Zwischenfeldebene des Reticle-Masking-Systems 51 auf das Reticle 7 ab.

Dieses Beleuchtungssystem bildet zusammen mit einem Projektionsobjektiv und einem verstellbaren Wafer-Halter eine Projektionsbelichtungsanlage für die Mikrolithographie von elektronischen Bauteilen, aber auch von optischen diffraktiven Elementen und anderen mikrostrukturierten Teilen.

Bei einem Wafer-Stepper wird auf dem Reticle 7 die gesamte einem Chip entsprechende strukturierte Fläche, im Allgemeinen ein Rechteck mit einem beliebigen Aspektverhältnis von z. B. 1 : 1 bis 1 : 2, insbesondere 1 : 1,3, so gleichmäßig wie möglich und so randscharf wie möglich beleuchtet.

Bei einem Wafer-Scanner wird auf dem Reticle 7 ein schmaler Streifen, ein Rechteck mit einem Aspektverhältnis von 1 : 2 bis 1 : 8, beleuchtet und durch Scannen das gesamte strukturierte Feld eines Chips seriell beleuchtet. Auch hier ist die Beleuchtung extrem gleichmäßig und randscharf (nur in Richtung senkrecht zur Scanrichtung) zu gestalten.

In Ausnahmefällen sind auch andere Formen der beleuchteten Fläche auf dem Reticle 7 möglich. Die Öffnung des Reticle-Masking-Systems 51 und der Querschnitt des Glasstabs 5 sind der benötigten Form genau angepaßt.

Die Ausführung der dem Glasstab 5 vorgelagerten Teile insbesondere der optischen Rasterelemente 8 und 9, ist so gewählt, daß die Eintrittsöffnung 5e nicht nur möglichst homogen, sondern auch mit höchstmöglichem Wirkungsgrad, d.h. ohne wesentliche Lichtverluste neben der Eintrittsöffnung 5e, ausgeleuchtet wird.

Dazu dienen folgende Maßnahmen:
Der vom Strahlaufweiter 14 kommende parallele Lichtstrahl mit rechteckigem Querschnitt und einer nicht rotationssymmetrischen Divergenz von θx = 1 mrad , θy = 3 mrad wird durch das erste diffraktive Rasterelement 9 nur soweit in der Divergenz, also dem Lichtleitwert, und seiner Form verändert, daß sich eine angenäherte Kreis-, Ring-, oder Quadrupolverteilung ergibt, wodurch auch die Austrittspupille - am Ort des zweiten Rasterelements 8 - des Objektivs 2 in der entsprechenden Form ausgeleuchtet wird. Die numerische Apertur des ersten diffraktiven Rasterelements 9 beträgt z.B. NA = 0,025.

Die geringe Divergenz in der Objektebene des Objektivs 2 erlaubt es, dieses mit kleinen Linsendurchmessern und damit kostengünstig und mit einfach erreichbarer guter Korrektur, sowie großem Zoombereich auszuführen. Durch die rotationssymmetrische Pupille werden die Linsenquerschnitte gut vom Lichtbündel ausgenützt. Es ist nur eine numerische Apertur von z. B. 0,025 des Objektivs 2 erforderlich.

Wie in DE 44 21 053 beschrieben, ist das Objektiv 2 ein Zoom-Objektiv (22) mit integriertem Axicon-Paar 21. Die Brennweite liegt im Bereich 600 mm bis 2000 mm mit einem dreifachen Dehnungsbereich, so daß partiell kohärente Beleuchtung mit den üblicherweise benötigten Werten 0,3 ≤ σ ≤ 0,9 erzeugt werden kann. Die Pupillendurchmesser am zweiten diffraktiven Element 8 liegen dann bei 50 mm bis 100 mm.

Durch Verstellen des Axicon-Paars 21 lassen sich zudem angepaßte Ringaperturbeleuchtungen einstellen. Durch zusätzliche Blenden oder spezielle Pyramidenform des Axicon-Paars 21 lassen sich zudem Multipol-, insbesondere Quadrupol-Beleuchtungen erzeugen.

Das Objektiv 2 ist gegenüber den in DE 44 21 053 beschriebenen Beispielen durch die geringe numerische Apertur vereinfacht. Zudem ist das Objektiv 2 ein Kondensor, denn das erste Rasterelement 9 als sekundäre Lichtquelle steht in einer Brennebene, das zweite Rasterelement 8 steht im parallelen Strahlengang (Bildweite ∞). Auch das Axicon-Paar 22 ist im parallelen Strahlengang angeordnet.

Das zweite Rasterelement 8 führt eine Divergenz von einzelnen Winkelgraden ein, und zwar in einer rechteckigen Verteilung mit einem Aspektverhältnis, das dem Aspektverhältnis der Eintrittsfläche 5e des Glasstabs 5 entspricht, also für einen Wafer-Stepper von z.B. 1 : 1,3.

So wird die erzeugte Divergenzverteilung in der Pupillenzwischenebene, in der das zweite optische Element 8 angeordnet ist, durch die Einkoppeloptik 4 auf die Eintrittsfläche 5e des Glasstabes 5 als Feldverteilung übertragen, die genau der Form und Größe der Eintrittsfläche 5e entspricht.

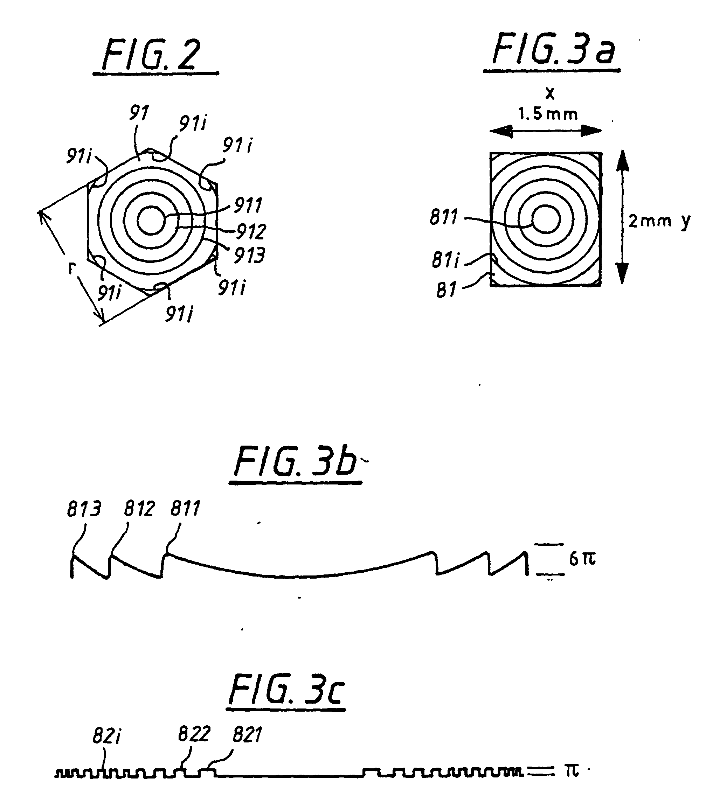

Für eine besonders vorteilhafte Ausführung des ersten Rasterelements 9 zeigt Figur 2a eine Ansicht auf ein Element 91 des zweidimensionalen Rasters, Figur 2b ein Phasenprofil davon. Das Element 91 ist sechseckig, da damit der zu erzeugenden rotationssymmetrischen Divergenzverteilung am besten entsprochen werden kann, und hat einen Seitenabstand von typisch r = 1 mm. Die Elemente 91 sind honigwabenartig zu dem zweidimensionalen Rasterelement 9 zusammengesetzt. Das entstehende Beugungsmuster hat damit mit der Laserwellenlänge Lambda = 248 nm die Periodizität Lambda / r = 2,48 ^{·} 10⁻⁴, entsprechend einem Winkel von 0,014°. Störungen durch Interferenzmuster entstehen daher nicht, weil der ankommende Laserstrahl eine räumliche Kohärenz von unter einem Millimeter und eine um Größenordnungen größere Divergenz hat.

Das Element 91 des Rasters ist eine beugende konkave Fresnel-Linse. Es weist acht ringförmige Stufen 911-914 ff. auf, mit einer Dicke (π/4) ^{·} Lambda (in der qualitativen Darstellung Figur 2b sind nur vier Stufen dargestellt). Hergestellt wird sie durch Photolithographie und Ätzen mit einer minimalen Strukturbreite von 1 µm.

Die Apertur des Elements 91 beträgt nur NA = 0,025. Eine Vielzahl von Elementen 91 ist zu einem rechteckigen diffraktiven optischen Rasterelement 9 zusammengesetzt, das die gesamte Querschnittsfläche des ankommenden Laserstrahls überdeckt. Der Beugungswirkungsgrad liegt bei über 80 %.

Die damit in der Austrittspupille des Objektivs 2, also am Ort des zweiten diffraktiven optischen Rasterelements 8 erreichte radiale Intensitätsverteilung ist als Querschnitt gesehen an eine Rechteckfunktion sehr gut angenähert, der Randabfall ist kontinuierlich und steil, mit 50 %-Punkten bei mehr als 0,9 mal, insbesondere über 0,95 mal, der Breite. Dazwischen ist der Intensitätsverlauf sehr homogen, ein rotationssymmetrisches Ripple liegt unter ± 5 % und hängt von der räumlichen Kohärenz und der Divergenz des Lasers 1 ab.

Das zweite diffraktive optische Rasterelement 8 ist eine Scheibe von 50 bis 100 mm Durchmesser mit stark anamorphotischer Wirkung. Es ist aus zweidimensional aneinandergereihten rechteckigen Elementen 81 mit rotationssymmetrischer Struktur aufgebaut, wovon eines in Figur 3a schematisch in Ansicht dargestellt ist. Das Seitenverhältnis x/y entspricht dem Aspektverhältnis der Eintrittsfläche 5e des Glasstabs 5 und der auf dem Reticle 7 ausgeleuchteten Fläche, hier x = 1,5 mm, y = 2 mm. Für die Größe eines Elements 81 gelten die zu den Elementen 91 gemachten Aussagen ebenfalls. Die Anzahl der Elemente 81 ist so hoch, daß eine Verstellung des Kohärenzgrades σ von 0,3 bis 0,9 ohne störende Auswirkungen bleibt.

Auch die Elemente 81 sind beugende Fresnel-Linsenelemente mit negativer Brennweite von ca. - 10,5 mm. Sie sind hergestellt als Grauton-Linsen mit stetigem Dickenverlauf von 0 bis 6 π x Lambda in drei Ringen 811 bis 81i, vgl. Figur 3b, die einen Querschnitt durch Figur 3a in x-Richtung zeigt.

Die erzeugte Divergenz liegt bei 0,5° bis 7° mit einem x/y-Aspektverhältnis entsprechend dem Aspektverhältnis der Eintrittsfläche 5e des Glasstabs 5.

Alternativ können die Elemente 81, wie im Querschnitt der Figur 3c gezeigt, als binäre diffraktive Phasenprofil-Linsen gestaltet werden, d.h. es sind nur Stege 821-82i einheitlicher Höhe π ^{·} Lambda, aber unterschiedlicher Breite und mit unterschiedlichem Abstand als beugende Strukturen vorhanden. Dem Vorteil kleinerer Ätztiefen steht das Problem kleinerer Strukturbreiten gegenüber.

Das gesamte zweite diffraktive optische Rasterelement 8 in der Anordnung nach Figur 1 bewirkt in der Eintrittsfläche 5e des Glasstabs 5 eine homogene Intensitätsverteilung, die in x- und y-Richtung jeweils eine angenäherte Rechteckfunktion mit einer Kantensteilheit und Welligkeit im Plateau-Bereich wie die Intensitätsverteilung auf der Eintrittsseite des Rasterelements 8, die vom ersten diffraktiven Rasterelement 9 geprägt ist.

Mit dieser gleichmäßigen Intensitätsverteilung wird eine sehr hohe Strahlungsbelastung des folgenden optischen Systems, insbesondere des Glasstabs, möglich, da alle Materialquerschnitte gleichmäßig und ohne schädliche Intensitätsspitzen durchstrahlt werden.

Alternativ zu den am Beispiel gezeigten diffraktiven optischen Rasterelementen können auch refraktive Linsenraster aus UVfestem Material, insbesondere Quarz, eingesetzt werden.

## Patentansprüche

1. Projektions-Mikrolithographie-Beleuchtungseinrichtung umfassend einen Laser (1) und ein Objektiv (2) mit einer Austrittspupille und einer Objektebene des Objektivs (2),
ein erstes optisches Rasterelement (9)
angeordnet in der Objektebene des Objektivs (2) oder in einer
dazu äquivalenten Ebene, und
ein zweites optisches Rasterelement (8)
angeordnet in der Austrittspupille des Objektivs (2)
oder in einer dazu äquivalenten Ebene,
wobei beide Rasterelemente (8,9) zweidimensionale Rasterstruktur aufweisen **dadurch gekennzeichnet, daß** die ausgangsseitige Divergenzverteilung des ersten optischen Rasterelements (9) so eng ist, daß das Objektiv (2) nur eine numerische Apertur kleiner als 0,1, vorzugsweise kleiner als 0,03, benötigt.

2. Beleuchtungseinrichtung nach Anspruch 1, **dadurch gekennzeichnet, daß** das erste optische Rasterelement (9) die rechteckförmige Divergenzverteilung des vom Laser (1, 14) kommenden Lichtbündels in eine kreis-, ring-, oder quadrupolförmige ausgangsseitige Divergenzverteilung umformt.

3. Beleuchtungseinrichtung nach Anspruch 1 oder 2, **dadurch gekennzeichnet, daß** das zweite Rasterelement (8) richtungsabhängige Divergenzen erzeugt.

4. Beleuchtungseinrichtung nach mindestens einem der Ansprüche 1-3, **dadurch gekennzeichnet, daß** das zweite optische Rasterelement (8) in der Austrittspupille des Objektivs (2), die eine definierende Ebene für die Pupille der Beleuchtungseinrichtung ist, angeordnet ist und die Divergenz um ein Mehrfaches erhöht.

5. Beleuchtungseinrichtung nach mindestens einem der Ansprüche 1-4, **dadurch gekennzeichnet, daß** das zweite optische Rasterelement (8) die Divergenzverteilung anamorphotisch umformt, so daß das ausgeleuchtete Feld (5e) der Beleuchtungseinrichtung rechteckig ist.

6. Beleuchtungseinrichtung nach Anspruch 5, **dadurch gekennzeichnet, daß** das Aspektverhältnis des rechteckigen Felds im Bereich 1 : 1 bis 1 : 2 liegt, die Einrichtung also für Wafer-Stepper geeignet ist.

7. Beleuchtungseinrichtung nach Anspruch 5, **dadurch gekennzeichnet, daß** das Aspektverhältnis im Bereich 1 : 2 bis 1 : 8 liegt, die Einrichtung also für Wafer-Scanner geeignet ist.

8. Beleuchtungseinrichtung nach mindestens einem der Ansprüche 1-7, **dadurch gekennzeichnet, daß** das Objektiv (2) ein Zoom-Objektiv, insbesondere ein Zweibis Vierfach-Zoom ist.

9. Beleuchtungseinrichtung nach mindestens einem der Ansprüche 1-8, **dadurch gekennzeichnet, daß** das Objektiv (2) ein verstellbares Axicon-Paar (21) enthält, mit dem wahlweise ringförmige Beleuchtungen erzeugt werden.

10. Beleuchtungseinrichtung nach Anspruch 8 und 9, **dadurch gekennzeichnet, daß** das Axicon-Paar (21) und die Zoomstellung (22) unabhängig voneinander einstellbar sind.

11. Beleuchtungseinrichtung nach mindestens einem der Ansprüche 1-10, **dadurch gekennzeichnet, daß** auf das zweite optische Rasterelement (8) ein Einkoppelobjektiv (4) und ein homogenisierender Glasstab (5) folgen, und daß der Querschnitt des Glasstabs (5) dem Aspektverhältnis des ausgeleuchteten Feldes der Beleuchtungseinrichtung angepaßt ist.

12. Beleuchtungseinrichtung nach mindestens einem der Ansprüche 1-11, **dadurch gekennzeichnet, daß** zwischen Laser (1) und erstem optischem Rasterelement (9) eine Spiegelanordnung (14) vorgesehen ist, welche den Strahlquerschnitt vergrößert und die Kohärenz reduziert.

13. Beleuchtungseinrichtung nach mindestens einem der Ansprüche 1 - 12, **dadurch gekennzeichnet, daß** das erste oder zweite optische Rasterelement (9,8) aus einer zweidimensionalen Anordnung von diffraktiven Elementen (91, 81) besteht.

14. Beleuchtungseinrichtung mit einem ersten oder zweiten optischen Rasterelement nach Anspruch 13, **dadurch gekennzeichnet, daß** ein diffraktives optisches Rasterelement (8, 9) aus einer Vielzahl im Raster angeordneter Phasenstufen-Fresnellinsen (81, 91) besteht.

15. Beleuchtungseinrichtung nach Anspruch 14, **dadurch gekennzeichnet, daß** die Phasenstufen-Fresnellinsen (81, 91) in der Randzone bis zu acht Stufen aufweisen, in der zentralen Zone bis zu 32 Stufen.

16. Beleuchtungseinrichtung nach Anspruch 13, **dadurch gekennzeichnet, daß** die diffraktiven Elemente (81, 91) rein binäre optische Elemente sind (Figur 3c).

17. Beleuchtungseinrichtung nach mindestens einem der Ansprüche 1-16, enthaltend ein erstes oder zweites optisches Rasterelement nach Anspruch 13, **dadurch gekennzeichnet, daß** ein diffraktives optisches Rasterelement (8, 9) aus einer Vielzahl im Raster angeordneter quasikontinuierlich strukturierter Fresnellinsen besteht (Figur 3b).

18. Beleuchtungseinrichtung nach mindestens einem der Ansprüche 14-17, **dadurch gekennzeichnet, daß** das Raster ein Rastermaß der Größenordnung 1 mm aufweist.

19. Beleuchtungseinrichtung nach mindestens einem der Ansprüche 14, 15, 18, **dadurch gekennzeichnet, daß** die Fresnellinsen (81, 91) bis auf eine nicht-periodische Phasenverschiebung zweidimensional periodisch im Raster angeordnet sind.

20. Beleuchtungseinrichtung nach mindestens einem der Ansprüche 1-19, **dadurch gekennzeichnet, daß** das erste oder zweite optische Rasterelement (9, 8) negative Brennweite hat.

21. Beleuchtungseinrichtung nach mindestens einem der Ansprüche 1-20, **dadurch gekennzeichnet, daß** das erste oder zweite optische Rasterelement (9, 8) aus einem Array refraktiver Mikrolinsen besteht.

22. Beleuchtungseinrichtung nach Anspruch 2, **dadurch gekennzeichnet, daß** die Mikrolinsen Fresnellinsen sind.

23. Beleuchtungsanordnung nach mindestens einem der Ansprüche 1-22, **dadurch gekennzeichnet, daß** das erste oder zweite optische Rasterelement (9, 8) den Lichtleitwert erhöht.

## Claims

1. Projection microlithography illuminator comprising a laser (1) and a lens (2) with an exit pupil and an object plane of the lens (2), a first optical grid element (9) arranged in the object plane of the lens (2) or in a plane equivalent thereto, and a second optical grid element (8) arranged in the exit pupil of the lens (2) or in a plane equivalent thereto, the two grid elements (8, 9) having a two-dimensional grid structure, **characterized in that** the output-side divergence distribution of the first optical grid element (9) is so narrow that the lens (2) requires only a numerical aperture of less than 0.1, preferably less than 0.03.

2. Illuminator according to Claim 1, **characterized in that** the first optical grid element (9) transforms the rectangular divergence distribution of the light bundle coming from the laser (1, 14) into a circular, annular or quadrupole-shaped output-side divergence distribution.

3. Illuminator according to Claim 1 or 2, **characterized in that** the second grid element (8) generates directionally dependent divergences.

4. Illuminator according to at least one of Claims 1-3, **characterized in that** the second optical grid element (8) is arranged in the exit pupil of the lens (2), which is a defining plane for the pupil of the illuminator, and increases the divergence by a multiple.

5. Illuminator according to at least one of Claims 1-4, **characterized in that** the second optical grid element (8) transforms the divergence distribution anamorphotically such that the illuminated field (5e) of the illuminator is rectangular.

6. Illuminator according to Claim 5, **characterized in that** the aspect ratio of the rectangular field is in the range of 1 : 1 to 1 : 2, and so the illuminator is suitable for wafer steppers.

7. Illuminator according to Claim 5, **characterized in that** the aspect ratio is in the range of 1 : 2 to 1 : 8, and so the illuminator is suitable for wafer scanners.

8. Illuminator according to at least one of Claims 1-7, **characterized in that** the lens (2) is a zoom lens, in particular a x 2 to a x 4 zoom lens.

9. Illuminator according to at least one of Claims 1-8, **characterized in that** the lens (2) includes an adjustable axicon pair (21) with the aid of which optional annular illuminations are produced.

10. Illuminator according to Claim 8 and 9, **characterized in that** the axicon pair (21) and the zoom position (22) can be set independently of one another.

11. Illuminator according to at least one of Claims 1-10, **characterized in that** the second optical grid element (8) is followed by a coupling lens (4) and a homogenizing glass rod (5), and **in that** the cross section of the glass rod (5) is adapted to the aspect ratio of the illuminated field of the illuminator.

12. Illuminator according to at least one of Claims 1-11, **characterized in that** provided between the laser (1) and the first optical grid element (9) is a mirror arrangement (14) which enlarges the beam cross section and reduces the coherence.

13. Illuminator according to at least one of Claims 1-12, **characterized in that** the first or second optical grid element (9, 8) comprises a two-dimensional arrangement of diffractive elements (91, 81).

14. Illuminator having a first or second optical grid element according to Claim 13, **characterized in that** a difffractive optical grid element (8, 9) comprises a multiplicity of phase step Fresnel lenses (81, 91) arranged in the grid.

15. Illuminator according to Claim 14, **characterized in that** the phase step Fresnel lenses (81, 91) have up to eight steps in the edge zone and up to 32 steps in the central zone.

16. Illuminator according to Claim 13, **characterized in that** the diffractive elements (81, 91) are purely binary optical elements (Figure 3c).

17. Illuminator according to at least one of Claims 1-16, including a first or second optical grid element according to Claim 13, **characterized in that** a diffractive optical grid element (8, 9) comprises a multiplicity of quasi-continuously structured Fresnel lenses arranged in the grid (Figure 3b).

18. Illuminator according to at least one of Claims 14-17, **characterized in that** the grid has a grid size of the order of magnitude of 1 mm.

19. Illuminator according to at least one of Claims 14, 15, 18, **characterized in that** the Fresnel lenses (81, 91) are arranged periodically in two dimensions in the grid except for a non-periodic phase shift.

20. Illuminator according to at least one of Claims 1-19, **characterized in that** the first or second optical grid element (9, 8) has a negative focal length.

21. Illuminator according to at least one of Claims 1-20, **characterized in that** the first or second optical grid element (9, 8) comprises an array of refractive microlenses.

22. Illuminator according to Claim 2, **characterized in that** the microlenses are Fresnel lenses.

23. Illuminator according to at least one of Claims 1-22, **characterized in that** the first or second optical grid element (9, 8) increases the photoconductance.

## Revendications

1. Dispositif d'illumination de microlithographie par projection comprenant un laser (1) et un objectif (2) avec une pupille de sortie et un plan d'objet de l'objectif (2), un premier élément de grille optique (9) disposé dans le plan d'objet de l'objectif (2) ou dans un plan équivalent à celui-ci et un deuxième élément de grille optique (8) disposé dans la pupille de sortie de l'objectif (2) ou dans un plan équivalent à celui-ci, les deux éléments de grille (8, 9) présentant une structure en grille bidimensionnelle, **caractérisé en ce que** la distribution divergente du côté de la sortie du premier élément de grille optique (9) est tellement étroite que l'objectif (2) nécessite seulement une ouverture numérique inférieure à 0,1, de préférence inférieure à 0,03.

2. Dispositif d'illumination selon la revendication 1, **caractérisé en ce que** le premier élément de grille optique (9) déforme la distribution de divergence rectangulaire du faisceau de lumière en provenance du laser (1, 14) en une distribution de divergence circulaire, annulaire ou quadripolaire du côté de la sortie.

3. Dispositif d'illumination selon la revendication 1 ou 2, **caractérisé en ce que** le deuxième élément de grille (8) produit des divergences en fonction de la direction.

4. Dispositif d'illumination selon au moins l'une des revendications 1 à 3, **caractérisé en ce que** le deuxième élément de grille optique (8) est disposé dans la pupille de sortie de l'objectif (2), laquelle est un plan défini pour la pupille du dispositif d'illumination, et augmente la divergence d'un multiple.

5. Dispositif d'illumination selon au moins l'une des revendications 1 à 4, **caractérisé en ce que** le deuxième élément de grille optique (8) déforme la distribution de divergence de manière anamorphotique de manière à ce que le champ éclairé (5e) du dispositif d'illumination soit rectangulaire.

6. Dispositif d'illumination selon la revendication 5, **caractérisé en ce que** le rapport d'aspect du champ rectangulaire est compris entre 1:1 et 1:2, le dispositif convient ainsi pour l'échelonnement des galettes.

7. Dispositif d'illumination selon la revendication 5, **caractérisé en ce que** le rapport d'aspect est compris entre 1:2 et 1:8, le dispositif convient ainsi pour le balayage des galettes.

8. Dispositif d'illumination selon au moins l'une des revendications 1 à 7, **caractérisé en ce que** l'objectif (2) est un objectif grossissant, notamment un zoom x2 à x4.

9. Dispositif d'illumination selon au moins l'une des revendications 1 à 8, **caractérisé en ce que** l'objectif (2) contient une paire d'axicons réglables (21) avec laquelle peuvent être générées au choix des illuminations en forme d'anneau.

10. Dispositif d'illumination selon les revendications 8 et 9, **caractérisé en ce que** la paire d'axicons (21) et la position du zoom (22) peuvent être réglées indépendamment l'une de l'autre.

11. Dispositif d'illumination selon au moins l'une des revendications 1 à 10, **caractérisé en ce que** le deuxième élément de grille optique (8) est suivi par un objectif d'injection (4) et une tige en verre d'homogénéisation (5) et que la section transversale de la tige en verre (5) est adaptée au rapport d'aspect du champ éclairé du dispositif d'illumination.

12. Dispositif d'illumination selon au moins l'une des revendications 1 à 11, **caractérisé en ce qu'**entre le laser (1) et un premier élément de grille optique (9) est prévu un arrangement de miroir (14) qui augmente la section transversale du rayon et réduit la cohérence.

13. Dispositif d'illumination selon au moins l'une des revendications 1 à 12, **caractérisé en ce que** le premier ou le deuxième élément de grille optique (9, 8) se compose d'un arrangement bidimensionnel d'éléments diffractifs (91, 81).

14. Dispositif d'illumination comprenant un premier ou un deuxième élément de grille optique selon la revendication 13, **caractérisé en ce qu'**un élément de grille optique diffractif (8, 9) se compose d'une pluralité de lentilles de Fresnel à paliers de phase (81, 91) disposées en grille.

15. Dispositif d'illumination selon la revendication 14, **caractérisé en ce que** les lentilles de Fresnel à paliers de phase (81, 91) présentent jusqu'à huit paliers dans la zone de bordure, jusqu'à 32 paliers dans la zone centrale.

16. Dispositif d'illumination selon la revendication 13, **caractérisé en ce que** les éléments diffractifs (81, 91) sont des éléments optiques binaires purs (figure 3c).

17. Dispositif d'illumination selon au moins l'une des revendications 1 à 16, comprenant un premier ou un deuxième élément de grille optique selon la revendication 13, **caractérisé en ce qu'**un élément de grille optique diffractif (8, 9) se compose d'une pluralité de lentilles de Fresnel structurées de manière quasi-continue disposées en grille (figure 3b).

18. Dispositif d'illumination selon au moins l'une des revendications 14 à 17, **caractérisé en ce que** la grille présente un maillage de l'ordre de 1 mm.

19. Dispositif d'illumination selon au moins l'une des revendications 14, 15, 18, **caractérisé en ce que** les lentilles de Fresnel (81, 91) sont disposées de manière périodique en deux dimensions dans la grille jusqu'à un déphasage non périodique.

20. Dispositif d'illumination selon au moins l'une des revendications 1 à 19, **caractérisé en ce que** le premier ou le deuxième élément de grille optique (9, 8) a une distance focale négative.

21. Dispositif d'illumination selon au moins l'une des revendications 1 à 20, **caractérisé en ce que** le premier ou le deuxième élément de grille optique (9, 8) se compose d'un réseau de micro-lentilles réfractives.

22. Dispositif d'illumination selon la revendication 2, **caractérisé en ce que** les micro-lentilles sont des lentilles de Fresnel.

23. Dispositif d'illumination selon au moins l'une des revendications 1 à 22, **caractérisé en ce que** le premier ou le deuxième élément de grille optique (9, 8) augmente la valeur de la conductivité optique.
